# FASCICULE DE BREVET EUROPEEN

(11) **EP 2 162 907 B1**
(45) Date de publication et mention de la délivrance du brevet: **05.01.2022**
(21) Numéro de dépôt: 08760578.8
(22) Date de dépôt: 05.06.2008
(51) Int. Cl.: H01L 21/98, H01L 25/065, H01L 21/683, H01L 21/56, B81C 1/00, H01L 23/538, H01L 23/14, H01L 23/13

(54) **DISPOSITIF COMPORTANT DES COMPOSANTS ENCASTRÉS DANS DES CAVITÉS D'UNE PLAQUETTE D'ACCUEIL ET PROCÉDÉ CORRESPONDANT**
VORRICHTUNG MIT BAUTEILEN IN HOHLRÄUMEN EINER EMPFANGSPLATTE UND ENTSPRECHENDES VERFAHREN
DEVICE INCLUDING COMPONENTS EMBEDDED IN CAVITIES OF A RECEPTOR PLATE AND CORRESPONDING METHOD

(30) Priorité: 07.06.2007 FR 0755575
(43) Date de publication de la demande: 17.03.2010
(73) Titulaire: Commissariat à l'Énergie Atomique et aux Énergies Alternatives, 75015 Paris (FR)
(72) Inventeur: SOURIAU, Jean-Charles, 38120 Saint-Égrève (FR); BALERAS, François, 38450 Saint Georges de Commiers (FR)
(74) Mandataire: Ilgart, Jean-Christophe
(86) Numéro de dépôt international: PCT/EP2008/057002
(87) Numéro de publication internationale: WO 2008/155231

(56) Documents cités:
- GB-A- 2 202 673
- US-A- 5 353 195
- US-A1- 2005 215 030
- US-A1- 2006 273 469
- US-A1- 2007 080 458
- US-A1- 2007 096 305
- US-B2- 7 202 107
- RAMA PULIGADDA ET AL: "High-Performance Temporary Adhesives for Wafer Bonding Applications" MATERIALS RESEARCH SOCIETY, 27 novembre 2006 (2006-11-27), - 1 décembre 2006 (2006-12-01) XP002495201 MATERIALS RESEARCH SOCIETY 2006 Fall Meeting, SYMPOSIUM Y Enabling Technologies for 3-D Integration

## Description

### DOMAINE TECHNIQUE ET ART ANTERIEUR

Le domaine de l'invention concerne l'assemblage de microsystèmes à l'échelle d'une plaquette en matériau semi-conducteur, par exemple en silicium.

Elle concerne notamment les applications pour lesquelles sont recherchées des technologies d'intégration à haute densité de composants passifs, de détecteurs ou composants optoélectroniques ou de MEMs directement sur les circuits, communément appelées "Above IC".

Actuellement, les procédés d'intégration hétérogène ne peuvent se faire que sur des plaquettes de silicium entières. Les procédés " Above IC " sont donc limités aux domaines où l'intégrateur du microsystème peut disposer de plaquettes, ce qui implique des coûts importants (de plusieurs centaines de milliers à des millions d'Euros avec le passage en 300mm) en termes de jeu de masques et de fabrication des plaquettes chez un fondeur. Dans ce contexte, il est compréhensible que ces coûts soient un frein à l'émergence de nouvelles technologies et que les acteurs soient très limités.

De plus, pour les applications comme la téléphonie, la surface active des circuits intégrés n'est pas suffisante pour y accueillir tous les éléments nécessaires au système (composant passifs, amplificateurs, switch, cmposants SAW ou BAW). Il est en effet nécessaire d'assembler les différents éléments sur des substrats de type PCB (circuit imprimé) ou céramique. Les architectures sont souvent complexes et l'assemblage et l'interconnexion nécessitent beaucoup d'opérations individuelles (placement des composants et câblage filaire).

Aujourd'hui l'intégration des microsystèmes est, de manière courante, réalisée par report des composants sur des céramiques ou PCB avec des composants passifs discrets type "CMS". Les composants sont soit collés soit soudés sur les PCB, les connexions électriques étant assurées par des fils métalliques de type "câblage filaire" ou par des brasures dans le cas où les plots de la puce sont en regard du PCB "flip chip". Ce dernier type de report est avantageux, car il réduit les longueurs d'interconnexion.

Il existe une autre technique dans laquelle on reconstitue une plaquette à partir de puces discrètes en les enrobant dans un polymère.

Cette technique, dans laquelle on colle temporairement la face active de composants nus sur un adhésif, puis on les enrobe et on réalise un reroutage par-dessus, a été publiée en 1992 par Chang-Lee Chen et al. Dans un article intitulé « Bond Wireless Multipchip packaging Technology for High Speed Circuits », paru dans "IEEE Transactions On component Hybrids and Manufacturing Technology", Vol. 15 N° 4, pages 451-456.

On connaît également, dans ce type de technique, les procédés décrits dans les documents US 5 353 498 et US 5 497 033, ainsi que la technique décrite dans le document FR 2 857 157. La technique décrite dans le document FR 2 864 342 s'applique à des composants déjà dans un boîtier ; elle est très complexe car il faut alors meuler une partie du boîtier pour reprendre les contacts des composants.

Un problème posé par la mise en oeuvre de ces techniques est celui de la courbure des plaques reconstituées et de leur fragilité. Une telle courbure est induite, lors de variations de température, par les différences de coefficient de dilatation thermique entre la résine d'enrobage et les composants en silicium. Un effet de rétrécissement ou de retrait de la résine d'enrobage peut en outre apparaître pendant son durcissement.

Il peut en résulter des courbures avec des flèches de plus de 100 µm pour des plaquettes de 100 mm de diamètre, ce qui est trop important pour une manipulation dans beaucoup d'équipements et peut être rédhibitoire pour certains procédés, par exemple nécessitant que la plaquette soit plaquée sur un support en vue d'une application homogène du procédé, comme c'est le cas pour un recuit de type « hot plate » (sur un support chaud).

Ce procédé reste donc difficilement industrialisable et peu fiable.

Un autre type de procédé met en œuvre un cadre dans lequel les composants sont intégrés. L'ensemble est collé sur un substrat.

Une difficulté rencontrée avec ce type de procédé est celle d'assurer un collage précis des composants et du cadre qui supporte le durcissement du matériau d'enrobage et qui soit réversible.

Un autre procédé de réalisation d'une structure intégrée de composants semiconducteurs est décrit dans le document US 7 202 107. Il consiste à utiliser un film adhésif double face comportant un coté permanent et un côté qui perd son adhésion lorsqu'il est chauffé. Le coté permanent est mis en contact avec un support et les composants sont reportés sur le côté à adhésion réversible.

Une difficulté rencontrée avec ce procédé est la séparation de la plaquette et de son support. En effet ce type de film est bien adapté pour le collage et le décollage de surface plane et rigide. Dans l'invention citée le matériau d'enrobage est déposé ou injecté à l'état liquide puis durci. Il se crée alors des liaisons plus intimes avec l'adhésif. Le retrait de ce dernier est alors délicat et nécessiterait avantageusement un pelage, ce qui n'est pas possible car le collage du film et du support est permanent.

Le document US 2007/080458 décrit un module hybride et un procédé pour le fabriquer. Dans le procédé selon ce document, des composants sont placés dans des cavités d'une plaquette d'accueil qui est collée sur un support temporaire grâce à une couche adhésive. On injecte ensuite de la résine dans les espaces non occupés des cavités avant de durcir cette résine. Finalement, le support et la couche adhésive sont retirés simultanément.

Le document US 2005/215030 décrit un procédé et un dispositif pour séparer une plaque de renfort fixée à un substrat semi-conducteur renforcé.

### EXPOSÉ DE L'INVENTION

L'invention concerne un procédé, selon la revendication 1, d'intégration de composants discrets dans une plaquette, dite plaquette d'accueil, cette plaquette présentant des cavités aptes à recevoir lesdits composants.

L'invention concerne également un dispositif électronique intégré de composants discrets, selon la revendication 10.

L'invention propose donc un dispositif électronique de composants intégrés, et une technique d'intégration de composants discrets, nus, dans une plaquette d'accueil, qui permet d'avoir la face active des composants dans un plan d'une face de cette plaquette d'accueil.

L'utilisation d'une couche adhésive thermosensible biface permet la rupture de l'adhésion avec la plaquette, mais aussi avec le support.

La couche adhésive thermosensible peut par exemple être du type comportant une couche de PET recouverte de chaque côté d'un film de matériau thermoexpansible ou termoadhésif, qui perd ses propriétés adhésives lorsqu'il est chauffé.

Un procédé selon l'invention peut comporter une étape préalable de formation d'une couche isolante électriquement, sur au moins une partie des surfaces de la plaquette, après formation des cavités.

L'étape a) peut comporter un assemblage préalable de la couche d'adhésif avec la plaquette, puis un assemblage du support avec la couche d'adhésif, les composants étant disposés sur cette couche d'adhésif avant ou après l'assemblage de la plaquette avec la couche d'adhésif.

En variante, cette étape comporte un assemblage préalable de la couche d'adhésif avec le support, puis un assemblage de la plaquette avec la couche d'adhésif, les composants étant disposés sur l'adhésif avant ou après l'assemblage de la plaquette avec la couche d'adhésif.

Le matériau de la plaquette et le matériau d'enrobage peuvent avoir des propriétés permettant de limiter ou d'éliminer les problèmes rencontrés avec les techniques connues, en particulier les problèmes de courbure des plaques et de leur fragilité.

Ainsi, de préférence, tant dans le dispositif que dans le procédé selon l'invention :
- le matériau de la plaquette a un coefficient d'expansion thermique compris entre 2 ppm/°C et 7 ppm/°C.
- et/ou le matériau d'enrobage latéral a un volume final inférieur à 30 % du volume de l'ensemble de la plaquette.

D'autres aspects de l'invention sont l'objet de revendications dépendantes.

### BRÈVE DESCRIPTION DES DESSINS

- Les figures 1A, 1B et 2 représentent des étapes du procédé selon l'invention. De plus, la figure 1B représente un dispositif selon l'invention,
- la figure 3 représente d'autres aspects d'un dispositif pouvant être formé par le procédé selon l'invention,
- les figures 4A - 4H sont des étapes d'un exemple de mise en oeuvre d'un procédé selon l'invention,
- les figures 5A et 5B représentent un exemple de couche adhésive pouvant être mise en œuvre dans le cadre de la présente invention, et une étape dans laquelle une plaquette est assemblée avec cette couche adhésive,
- la figure 6 représente le processus de décollement par glissement lors de l'utilisation d'un autre type d'adhésif, non couvert par les revendications,
- la figure 7 est une vue agrandie d'une portion d'un dispositif obtenu par un procédé selon l'invention.

### EXPOSÉ DÉTAILLÉ DE MODES DE RÉALISATION DE L'INVENTION

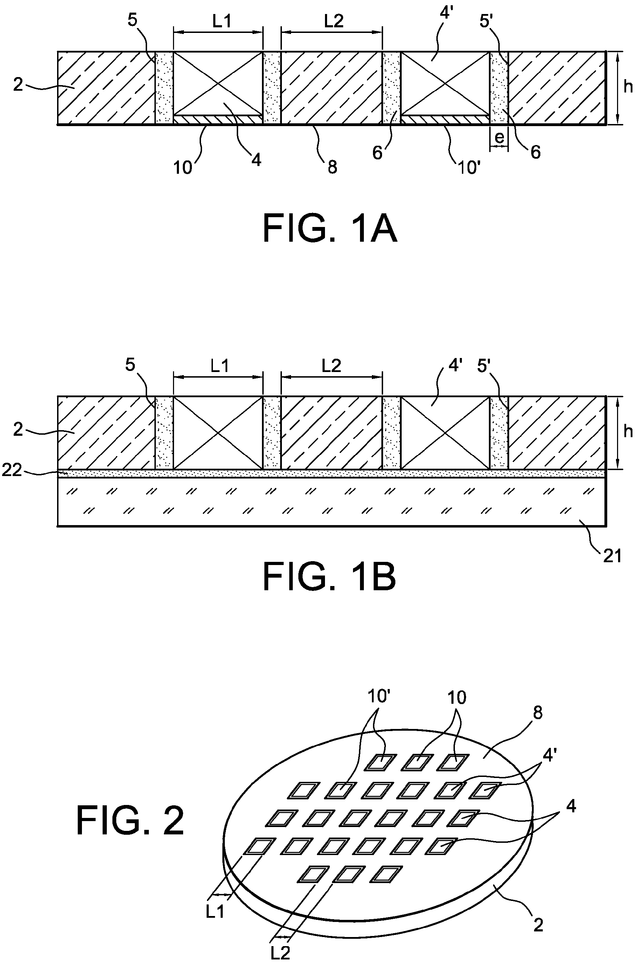

Deux exemples de dispositifs sont représentés en coupe sur les figures 1A et 1B.

Chacun de ces deux dispositifs comporte une matrice 2, aussi appelée plaquette ou encore plaquette d'accueil, par exemple en matériau semi-conducteur, d'épaisseur h. Un ou plusieurs composants électroniques 4, 4' qui peuvent être tous identiques ou être différents entre eux (ils peuvent notamment avoir des épaisseurs différentes les unes des autres), sont contenus dans des cavités 5, 5' de cette matrice. Les faces actives de ces composants sont désignées par les références 10, 10' : il s'agit des faces sur lesquelles sont réalisés les composants élémentaires définissant les fonctionnalités de chaque composant. Ces faces actives 10, 10' des composants affleurent le plan de la face 8, dite face avant, de la matrice 2 d'accueil. Un ou plusieurs des composants 4 peuvent être des composants semiconducteurs, en particulier du domaine de la microélectronique, tels que des circuits intégrés, et/ou des capteurs MEMS, et/ou des composants optiques (MOEMS) et/ou des biocomposant et/ou des commutateurs.

Deux cavités 5, 5' voisines peuvent être séparées par une distance désignée par L₂, L₁ désignant quant à elle la largeur d'un composant. Les dimensions correspondantes (largeur, distance de séparation de deux cavités voisines) dans la deuxième direction du plan 8 (cette deuxième direction est perpendiculaire au plan de la figure) sont sensiblement identiques à L₁, L₂. On retrouve ces dimensions sur la figure 2. Des ordres de grandeur pour les dimensions h, L₁ et L₂ sont donnés plus loin.

Un matériau d'enrobage 6 entoure les composants et assure le lien entre leurs surfaces latérales et la paroi des cavités 5, 5'.

Sur la figure 1B, le dispositif qui vient d'être décrit repose en outre sur un substrat 21 muni d'une couche 22 d'adhésif thermosensible biface. Il s'agit donc d'une couche dont chaque face est adhésive jusqu'à une certaine température et qui perd ce caractère adhésif au dessus de cette température. Autrement dit, dans ce mode de réalisation on trouve successivement le substrat 21, la couche 22, puis les composants et leur enrobage 6. Dans une alternative qui ne fait pas partie de l'invention revendiquée, le substrat 21 et la couche 22 peuvent être transparents. La couche 22 de matériau adhésif est donc interposée entre d'une part le substrat support et d'autre part le plan de la face avant 8 de la plaquette d'accueil 2. Ce plan et la face active des composants sont fixés sur cette couche 22 d'adhésif.

La figure 2 représente un substrat constitué de la matrice d'accueil 2. Dans cette matrice sont insérés une pluralité de composants 4, 4' dont les surfaces actives 10, 10' sont visibles, dans le plan d'une face 8 de la matrice. Les différents composants peuvent avoir des épaisseurs différentes, et en particulier différentes de celle de la plaquette 2. La face 8 peut avoir été processée, avant accueil des composants 4. Elle peut être ensuite traitée par des procédés de type « above IC », comme expliqué ci-dessous.

On privilégie un matériau de la matrice 2 tel que son coefficient d'expansion thermique (CTE) soit identique ou très proche de celui du ou des composants électroniques 4, lui-même défini par le ou les matériaux semi-conducteurs de ce ou de ces composants. Le CTE de la matrice 2 est alors compris entre 2 ppm/°C et 7 ppm/°C. Le choix d'un matériau de plaquette 2 ayant un CTE dans cette gamme permet de fortement réduire les problèmes de courbure, dus, dans les dispositifs connus, à des différences importantes de CTE entre les matériaux des composants et celui de la matrice.

Le choix de la matrice 2 d'accueil dépendra le plus possible de la nature des composants 4 à y insérer. Généralement ceux-ci sont en silicium mais d'autres matériaux semi conducteurs, comme de l'AsGa ou de l'InP, peuvent être présents.

Si les composants 4 sont en silicium, ou réalisés à partir d'un substrat essentiellement en silicium, ou de type SOI, on choisira de préférence pour la matrice d'accueil 2 un matériau dont le CTE est compris entre 2 ppm/°C et 7 ppm/°C ou même entre 2 ppm/°C et 5 ppm/°C. Par exemple on choisira une matrice d'accueil elle-même en silicium.

Si les composants 4 sont en InP ou en AsGa, ou réalisés à partir d'un substrat essentiellement en InP ou en AsGa, on choisira de préférence pour la matrice d'accueil 2 un matériau dont le CTE est compris entre 3,5 ppm/°C et 7 ppm/°C. Par exemple on choisira une matrice d'accueil elle-même, respectivement, en InP ou en AsGa.

Encore à titre d'exemple de matériau de matrice 2 d'accueil, on peut citer le Silicium (CTE compris entre 2,5 et 4,2 ppm/°C en fonction de la température, 2,5 ppm à 20°C), ou l'AsGa (CTE d'environ 5,4 ppm/°C), ou l'InP (CTE d'environ 4,6 ppm/°C), ou le Verre borosilicate (CTE d'environ 4,5 ppm/°C), ou le Verre d'aluminosilicate (CTE d'environ 4,7 ppm/°C), ou le Nitrure d'aluminium (CTE compris sensiblement entre 2,1 et 4,4 ppm/°C), ou la Mullite (CTE compris sensiblement entre 3,5 et 4,4 ppm/°C), ou les céramiques (CTE voisin de 4 ppm/°C). On cherche de préférence à choisir un matériau dont le CTE est adapté. Avantageusement on choisira le même matériau que celui utilisé comme substrat pour la réalisation des composants 4.

Le matériau d'enrobage 6, d'épaisseur e, entoure les composants 4. Il assure une liaison ou une bonne adhérence entre les flancs ou les bords du ou des composants, et le flanc de la ou des cavités 5 correspondantes. Ce matériau d'enrobage a, de préférence, un coefficient d'expansion thermique bas, c'est-à-dire par exemple compris entre 1 ppm/°C et 10 ppm/°C. De préférence encore, il ne présente pas ou peu de rétreint ou de contraction pendant son durcissement.

A titre d'exemple de matériau d'enrobage 6, on peut citer la résine époxy, le polyuréthane, l'élastomère, les matériaux silicones, l'acrylique, les méthacrylates, le polypropylène, ou un verre fusible. Chacun de ces matériaux a un CTE élevé; pour le diminuer le matériau choisi peut être mélangé avec des particules de silice.

En ajustant la taille des cavités 5 avec celle des composants 4, on peut chercher à minimiser le volume de matériau d'enrobage 6, notamment dans le cas d'un matériau de la plaquette 2 de CTE proche de celui des composants. On peut alors maximiser la proportion de matériau solide de même CTE que les composants 4, ou de CTE voisins ou proches de ces composants, dans la plaquette 2 reconstituée. Par rapport à la plaquette finale (comportant le substrat 2, les composants 4 et le matériau d'enrobage), l'ensemble constitué par la plaquette initiale (munie de ses cavités 5, 5') et les composants 4 est de préférence majoritaire, par exemple à plus de 70 % ou de 80 % en volume. Le matériau d'enrobage 6 est alors présent à moins de 30 % ou de 20 % en volume de la plaquette finale intégrée.

Cette faible proportion de matériau d'enrobage, éventuellement combiné à un matériau de la plaquette 2 ayant un CTE dans les gammes indiquées ci-dessus, permet d'éliminer ou de fortement limiter les problèmes de courbure, dus, dans les dispositifs connus, à des différences importantes de CTE entre les matériaux des composants et celui de la matrice.

Des ordres de grandeur pour les dimensions h, e, L₁ et L₂ peuvent être les suivants :
- h peut être compris entre 10 µm et quelques mm, par exemple 5 mm,
- e peut être compris entre 20 µm et quelques mm, par exemple 1 mm,
- L₁ peut être compris entre 100 µm et quelques mm, par exemple 5 cm,
- L₂ peut être compris entre 100 µm et quelques mm, par exemple 5 cm,

Ces valeurs sont des exemples et d'autres valeurs sont possibles en dehors des plages indiquées.

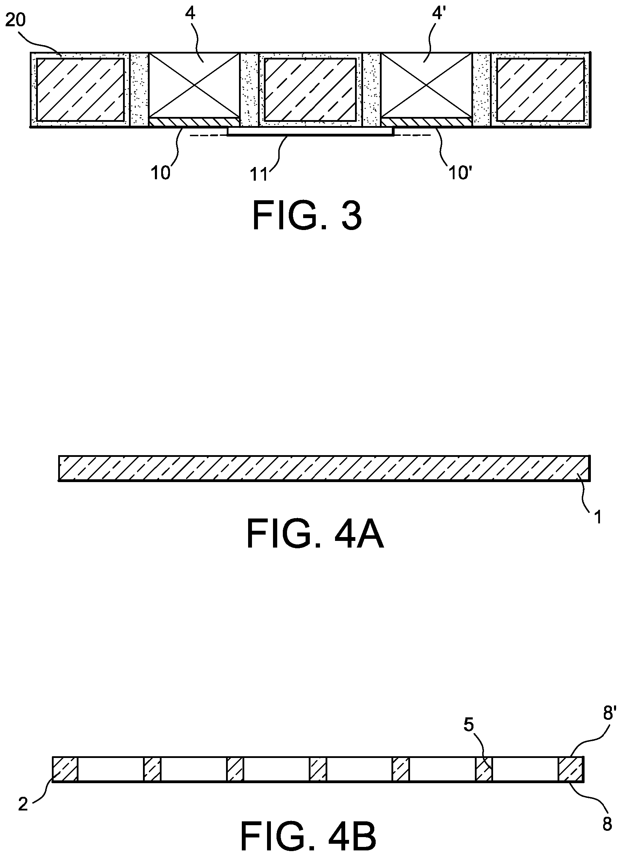

Comme illustré sur la figure 3, qui représente également une vue en coupe d'un dispositif intégré obtenu par un procédé selon l'invention, une couche 20 isolante électriquement peut être formée ou déposée sur tout ou partie des surfaces de la matrice 2, si celle - ci a des propriétés semi-conductrices, pour que les composants 4 ne soient pas gênés par ces mêmes propriétés. Cette couche isolante 20 est réalisée par exemple par oxydation thermique ou par dépôt en couche mince (d'épaisseur comprise entre quelques nm et quelques µm).

La matrice 2, avec ses composants 4 et le matériau d'enrobage 6, peut, après avoir été réalisée, être l'objet de divers traitements ou procédés. On peut ainsi citer divers exemples de procédés de type «Above IC», susceptibles d'être réalisés, sur la face 8, de la plaquette 2 et les faces actives 10,10' des composants, après élimination du support 21 et de la couche 22, comme expliqué plus loin :
- l'intégration de composants passifs en couche mince (résistances et/ou capacités et/ou inductances),
- reroutage de contacts électriques et/ou interconnexion des composants 4, 4' entre eux (par exemple, sur la figure 3, une simple connexion 11 est représentée entre les composants 4; un ensemble complexe de pistes et de contacts peut être réalisé en surface de la plaquette),
- intégration, sur la surface 10 des composants 4, de composants optiques (par exemple de micro lentilles) ou de plots d'interconnexion, par exemple par croissance de billes fusibles, ou transfert de billes, ou fabrication de "Stud Bump", ou croissance de micro-inserts, ou hybridation de composants sur la plaquette (Chip on Wafer).

Un exemple de procédé selon l'invention va être donné, en liaison avec les figures 4A-4G.

On sélectionne (figure 4A) une plaquette 1, de préférence en un matériau ayant un CTE tel qu'indiqué ci-dessus. Par exemple elle est en silicium vierge ou elle est déjà traitée. Cette plaquette peut comporter, entre autres, des mires de positionnement et/ou des composants (par exemple en couche mince) et/ou des vias conducteurs qui traversent la plaquette.

On réalise dans cette plaquette (figure 4B) des cavités 5, par une technique telle que la gravure laser, la gravure KOH ou l'usinage ultrason ou le sablage. On a ainsi formé la plaquette d'accueil 2.

Comme déjà indiqué, il peut être ensuite avantageux d'en passiver les surfaces à nu, par oxydation thermique ou par dépôt d'un matériau isolant de type SiO₂, SiN etc...

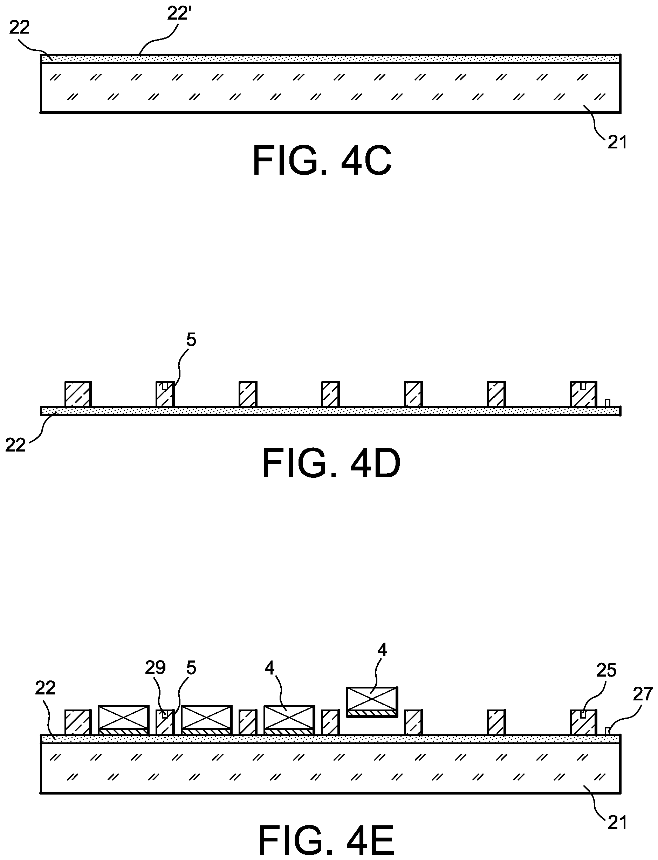

Par ailleurs, on procède (figure 4C) au montage d'une couche 22 d'adhésif thermosensible biface sur un support 21, rigide et plan. Sur la face 22' de la couche 22 opposée au substrat 21, la face 8, dite face avant de la plaquette, va être reportée. Une couche 22 d'adhésif thermosensible biface présente des propriétés adhésives sur ses deux faces. Mais une quelconque des deux faces perd ses propriétés adhésives dès lors qu'elle est chauffée au dessus d'une certaine température.

Le support 21 est par exemple une autre plaquette, en silicium ou en verre. Avantageusement, cette autre plaquette a également un CTE proche ou même identique à celui de la matrice d'accueil 2 et des composants 4 afin d'assurer un bon positionnement des composants (en limitant les déplacements et/ou les contraintes au moment du durcissement de la résine (réalisé par exemple par chauffage autour de 200°C).

En variante (figure 4D) on monte d'abord la couche 22 de matériau thermosensible biface sur la face avant de la plaquette de la figure 4B (plaquette munie des cavités 5), cet ensemble étant ensuite reporté sur le substrat 21.

Quelle que soit la variante (figure 4C ou 4D) utilisée, l'assemblage du support, de l'adhésif et de la plaquette conduit à une structure comportant la plaquette 2 avec ses cavités 5, la couche 22 et le support 21.

On procède ensuite au placement des composants 4 dans les cavités 5 (figure 4E).

Les équipements de placement de composants 4 permettent d'atteindre une précision latérale micronique, avec un parallélisme meilleur que 5.10⁻⁴ rad. Ces valeurs sont suffisantes pour reprendre des contacts sur les plots de connexion des composants situés sur la face active (après retrait du support) et qui ont généralement une largeur de l'ordre de quelques dizaines de µm.

On positionne alors les composants 4 avec leur face active 10 tournée vers la couche d'adhésif 22. L'alignement dans les cavités peut être réalisé grâce à des mires - désignées sur la figure 4E par les références 25, 27, 29 - qui auront été réalisées au préalable, soit sur la plaquette d'accueil 2, soit sur la couche d'adhésif 22.

Selon une variante de cette étape on dispose d'abord les composants sur la couche adhérente 22, qui repose elle-même sur le substrat 21, et, ensuite, on rapporte la matrice d'accueil 2, dont les cavités 5 sont alors positionnées de manière à englober les composants 4.

Dans les deux cas la tenue temporaire des composants sur le support 21 se fait grâce à la couche d'adhésif 22 déposée sur le support 21 (figure 4E). Cette couche d'adhésif 22 est apte à supporter le traitement thermique ultérieur de durcissement de la résine 6, c'est à dire que sa température de décollement est supérieure à celle de durcissement de la résine 6.

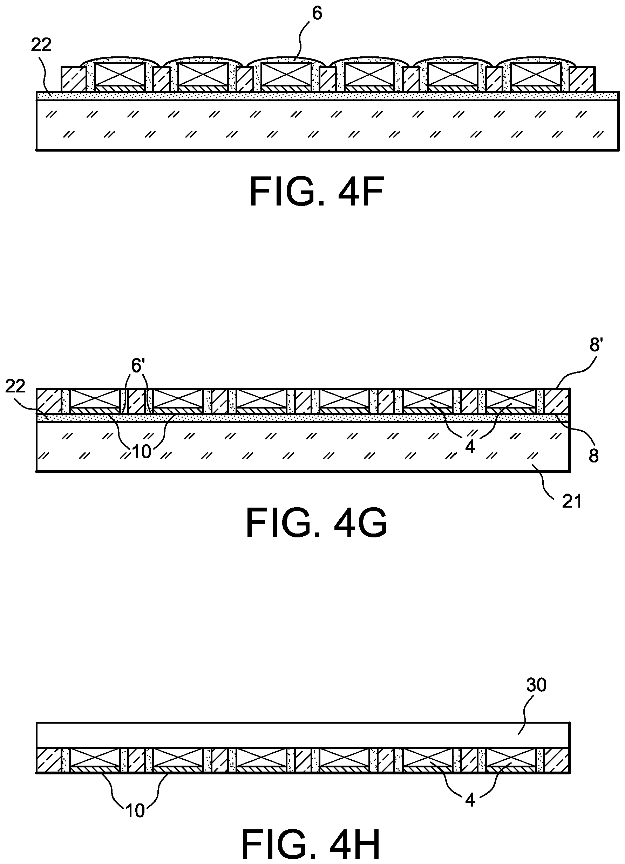

On procède ensuite au remplissage de l'espace libre, dans chaque cavité 5, par le matériau 6 d'enrobage (figure 4F), par exemple dans les proportions indiquées ci-dessus (le matériau 6 représente moins de 30 % ou de 20 % en volume de l'ensemble de la plaquette finale). Ce matériau est par exemple dispensé localement à la seringue ou bien, de façon plus grossière, en déposant une ou des grosses gouttes sur la plaquette. La pénétration de la résine d'enrobage dans les cavités 5 pourra être facilitée par une mise sous vide. Ce matériau de remplissage 6 est ensuite durci par chauffage à une température qui ne supprime pas les propriétés d'adhérence de la couche d'adhésif 22.

Un amincissement et un polissage de la face arrière 8' peuvent être ensuite réalisés (figure 4G).

On procède ensuite à une montée en température, pour dépasser la température de décollement de la couche d'adhésif 22, jusqu'à décollement du support 21. A ce stade, la couche d'adhésif 22 reste attachée à la plaquette 2, aux interfaces du matériau d'enrobage 6 et du film 22. Ces interfaces (zones désignées sur la figure 4G par la référence 6') constituent des points d'accroche résiduelle de la couche 22. Puis on procède, là encore par montée en température, au retrait du film 22, ce qui conduit à la structure de la figure 1A par exemple.

Selon un procédé qui ne fait pas partie de l'invention revendiquée, il est possible de libérer la couche d'adhésif 22 par insolation à travers le support 21 si ce dernier est transparent. Cette insolation permet d'abord de libérer la couche d'adhésif 22 du substrat 21. Il est ensuite possible de séparer, par pelage, la couche d'adhésif 22 de la plaquette.

La face avant 8 du composant obtenu n'a pas à être processée ou traitée car elle contient les faces actives 10 des composants 4.

Ensuite la plaquette peut être réintroduite dans une ligne de type microélectronique pour les étapes «Above IC», par exemple du type déjà décrit ci-dessus.

Après élimination du support 21 et de la couche 22, on peut coller la plaquette 2 sur une deuxième plaquette 30 afin de rigidifier l'ensemble (figure 4H). L'assemblage avec la deuxième plaquette 30 peut être réalisé avant élimination du support 21 et de la couche 22. D'une manière générale, les couches d'adhésif 22 en matériau thermo-expansible peuvent perdre leurs propriétés adhésives à des températures variées, par exemple sensiblement comprises entre 100°C et 200°C. A une température inférieure, ces propriétés adhésives sont conservées. Ces températures sont compatibles avec les températures de durcissement de matériau d'enrobage 6. Autrement dit, le durcissement du matériau d'enrobage démarre avant que la couche 22 ne perde ses propriétés adhésives: la température de durcissement du matériau 6 est inférieure à la température qui fait perdre ses propriétés adhésives à la couche 22. Le choix de la composition exacte de cette couche 22 dépend aussi des vitesses de durcissement du matériau d'enrobage 6. On cherche en effet à ce que ce dernier soit suffisamment dur avant que le film 22 ne se soit décollé.

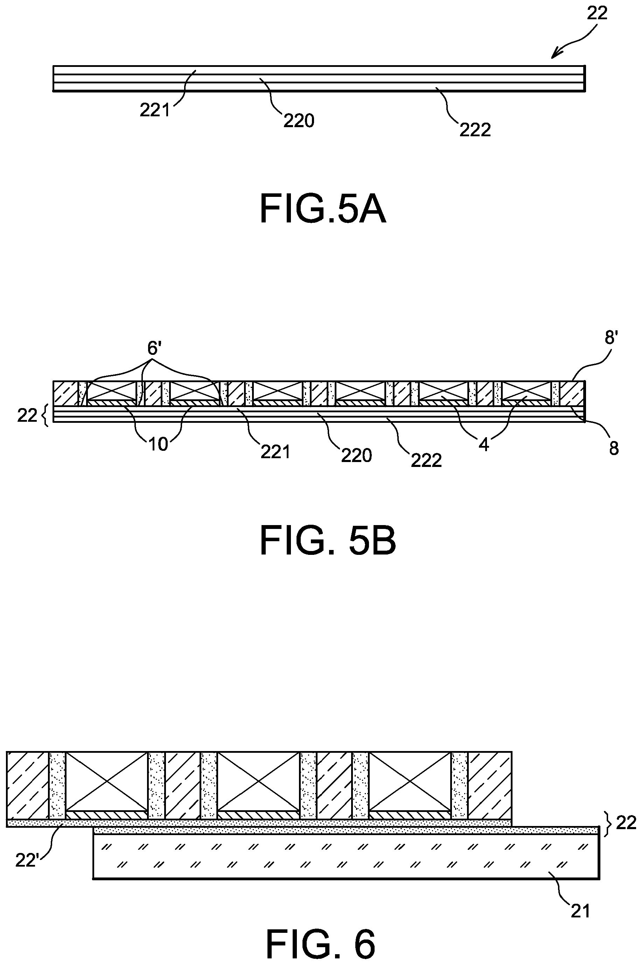

Un exemple de couche adhésive 22 pouvant être avantageusement utilisée dans le cadre de la présente invention comporte, comme illustré sur la figure 5A, un substrat 220 en PET recouvert sur ses deux côtés par une couche 221, 222 de type « thermal release », ou encore en un matériau thermo-expansible, qui perd ses propriétés adhésives lorsqu'il est chauffé de chaque côté.

L'utilisation de ce type de couche dans la présente invention présente plusieurs avantages, notamment le suivant: comme on procède d'abord au décollement du support 21 (la couche 22 restant donc temporairement fixée à la plaquette), puis à celui de la plaquette (on sépare alors la couche 22 de la plaquette), le film 220 de PET entre les 2 couches 221, 222 assure temporairement une rigidité suffisante après séparation du support 21.

Des couches de ce type sont par exemple fabriquées par Haeun Chemitec Co Ltd et commercialisés sous le nom de Rexpan.

Il peut être avantageux, selon un exemple non couvert par les revendications, d'utiliser un film comportant un adhésif 221, 222, de type thermo-expansible, différent de chaque coté du substrat 220 :
- un premier adhésif, par exemple l'adhésif 221, est en contact avec le support 21 et est décollable à une première température,
- un deuxième adhésif, par exemple l'adhésif 222, est en contact avec la plaquette 2 et est décollable à une deuxième température, supérieure à la première. Ainsi, cet adhésif n'est décollé qu'après durcissement du matériau d'enrobage 6. Ceci est intéressant lorsque la durée de durcissement du matériau d'enrobage 6 est importante. En effet, lorsqu'ils sont trop longtemps chauffés, les films adhésifs ont tendance à redevenir adhérents et sont plus difficiles à retirer. Dans ce cas, il est avantageux de pouvoir décoller le support 21 bien que le matériau d'enrobage 6 ne soit pas complément durci.

Pour le décollement de ce type de film à l'issue de l'étape de la figure 4G on procède ensuite à une montée en température jusqu'à décollement du support 21 (figure 5B). A ce stade, la couche adhésive 22 reste attachée à la plaquette, aux interfaces du matériau d'enrobage 6 et du film 22. Ces interfaces (zones désignées sur la figure 5B par les références 6') constituent des points d'accroche résiduelle de la couche 22. Des liaisons mécaniques plus fortes, à l'interface 6' matériau d'enrobage 6 - adhésif 22, au moment du durcissement, sont probablement dues à une pénétration du liquide dans les interstices présents à la surface de l'adhésif et/ou à la création de liaisons chimiques.

Puis on procède, également par une montée en température, au retrait du film 22 ce qui conduit à la structure de, par exemple, la figure 1A.

Un autre type de couche adhésive 22, qui n'est pas mis en œuvre dans la cadre de la présente invention, est une résine thermodémouillante, telle que celles proposées par « Brewer Science ».

Ce deuxième type de résine reste dure pendant le durcissement du matériau d'enrobage et est thermo-démouillante. Elle permet de séparer aisément la plaquette et le support à des hautes températures, par exemple environ 250°C pendant quelques minutes, par glissement des deux surfaces en contact, celle de la couche 22 et celle du substrat en contact avec cette surface. Cette étape est représentée sur la figure 6. Sur cette figure, une partie 22' du film 22 reste sur la plaquette 2 : il s'agit de résidus qui sont facilement nettoyables avec des solvants adaptés proposés par les fabricants de résines.

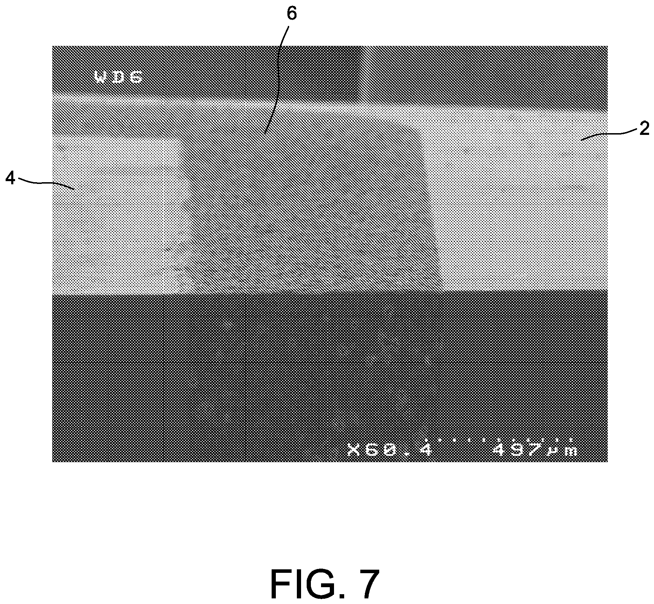

Les deux exemples de films 22 thermoadhésifs proposés ci-dessus permettent d'intégrer des composants dans des plaquettes avec une tolérance de planéité en z inférieure à 5pm. Ainsi la figure 7 est une vue agrandie d'une portion d'un dispositif obtenu par un procédé selon l'invention, avec une portion de cadre 2 en Si, d'un composant 4 en Si et du matériau d'enrobage 6. Ce cliché montre la bonne planeité obtenue.

Par rapport aux technologies d'assemblage conventionnelles, l'invention intègre des composants non plus sur une plaquette (technique dite « Chip On Wafer ») mais dans une plaquette 2 (technique dite « Chip In Wafer »). Leur face active 10 nue est dans le plan 8 de la face polie de la plaquette, ce qui permet de les réintroduire dans une ligne microélectronique et de continuer un traitement par des procédés « Above-IC » à haute densité.

De plus, un procédé selon l'invention permet de mixer des composants 4 déjà testés (« Known Good Die »), de sources et d'épaisseurs différentes dans une même plaquette 2. Dans un exemple qui ne fait pas partie de l'invention revendiquée, il est possible d'intégrer des composants servant uniquement de passage conducteur entre les deux faces de la plaquette.

La plaquette utilisée dans un procédé ou un dispositif selon l'invention revendiquée peut être en matériau semi-conducteur, par exemple en silicium ou en AsGa ou en InP, ou être de type SOI, ou être en un verre, par exemple de type borosilicate ou aluminosilicate, ou être en nitrure d'aluminium ou en mullite.

De plus, la plaquette, ou matrice, d'accueil utilisée dans un procédé ou un dispositif selon l'invention revendiquée peut être vierge ou bien avoir subit au préalable des traitements sur l'une et/ou l'autre de ses deux faces, par exemple : une passivation des surfaces (dépôt d'un isolant) et/ou une gravure et/ou un dépôt de mires de positionnement et/ou fabrication de composants passif en couche mince et/ou fabrication de vias conducteurs etc....

Après que le procédé selon l'invention a été effectué, la plaquette peut ensuite être introduite en pré- ou post-process dans une ligne de fabrication de microélectronique ou microsystème.

Parmi les exemples d'opérations technologiques qui peuvent être réalisées sur la plaquette d'accueil après que le procédé selon l'invention a été effectué, on peut citer l'intégration de composants passifs en couche mince, ou tout autre procédé de type « Above-IC », la fabrication de "vias" métallisés, le re-routage de plots de contact, les techniques de "micro bumping", le report de composants.

L'invention permet en particulier d'intégrer et de connecter des composants discrets issus de différentes filières (Si, SiGe, AsGa, SOI, InP) et de participer à la finalisation d' un système, avec un haut niveau d'intégration, par des opérations qui sont réalisées collectivement à l'échelle d'une plaquette.

## Revendications

1. Procédé d'intégration de composants discrets (4, 4') dans une plaquette (2), dite plaquette d'accueil, pour former un dispositif électronique intégré de composants discrets, cette plaquette présentant des cavités (5) aptes à recevoir lesdits composants, procédé dans lequel :
a) on réalise un empilement comportant un support (21), une couche (22) d'adhésif thermosensible biface, cette couche d'adhésif ayant deux faces dont chacune est adhésive et thermosensible, la plaquette (2) et les composants (4, 4') disposés dans lesdites cavités (5) de manière à ce que leur face active (10) soit dans un même plan qu'une face (8), dite face avant, de la plaquette d'accueil, cette face avant étant assemblée avec la couche (22) d'adhésif thermosensible biface,
b) on injecte un matériau d'enrobage (6) latéral des composants dans les cavités, la température de durcissement de ce matériau (6) étant inférieure à la température de décollement, qui fait perdre ses propriétés adhésives à la couche (22) d'adhésif thermosensible biface,
c) on réalise un durcissement par chauffage du matériau d'enrobage (6) à une température qui ne supprime pas les propriétés d'adhérence de la couche (22) d'adhésif thermosensible biface,
d) puis on élimine le support (21) et la couche d'adhésif thermosensible biface (22), d'abord par une 1^{ère} montée en température pour dépasser la température de décollement de la couche d'adhésif thermosensible biface (22) et décoller le support (21), puis par une 2^{ème} montée en température pour éliminer des points d'accroche résiduelle aux interfaces du matériau d'enrobage et de la couche d'adhésif afin de séparer la couche (22) d'adhésif de la plaquette.

2. Procédé selon la revendication 1, comportant une étape préalable de formation d'une couche (20) isolante électriquement, sur au moins une partie des surfaces de la plaquette, après formation des cavités (5).

3. Procédé selon l'une des revendications 1 ou 2, dans lequel l'étape a) comporte :
a1) un assemblage préalable de la couche d'adhésif (22) avec la plaquette (2), puis un assemblage du support (21) avec la couche d'adhésif, les composants étant disposés sur cette couche d'adhésif avant ou après l'assemblage de la plaquette avec la couche d'adhésif;
a'1) ou un assemblage préalable de la couche d'adhésif (22) avec le support (21), puis un assemblage de la plaquette (2) avec la couche d'adhésif (22), les composants étant disposés sur l'adhésif avant ou après l'assemblage de la plaquette avec la couche d'adhésif.

4. Procédé selon l'une des revendications 1 à 3, comportant en outre une étape d'amincissement de la face arrière de la plaquette (2) d'accueil, après l'étape c).

5. Procédé selon l'une des revendications 1 à 4, comportant en outre, après l'étape c) et avant ou après l'étape d), une étape d'assemblage de la plaquette avec un substrat (30) de rigidification.

6. Procédé selon l'une des revendications 1 à 5, au moins une partie des cavités (5) étant réalisée de manière à traverser la plaquette d'accueil sur toute son épaisseur et à déboucher sur chacune de ses faces (8, 8').

7. Procédé selon l'une des revendications 1 à 6, la plaquette d'accueil comportant en outre un ou plusieurs composants et/ou une ou plusieurs mires (25, 27, 29) .

8. Procédé selon l'une des revendications 1 à 7, le matériau de la plaquette (2) ayant un coefficient d'expansion thermique compris entre 2 ppm/°C et 7 ppm/°C et/ou le matériau d'enrobage latéral (6) ayant un volume final inférieur à 30 % du volume de l'ensemble de la plaquette.

9. Procédé selon l'une des revendications 1 à 8, le support (21) étant décollé alors que le matériau d'enrobage n'est pas encore complètement durci.

10. Dispositif électronique intégré de composants discrets, comportant :
- une plaquette (2), dite plaquette d'accueil, présentant des cavités (5) contenant lesdits composants (4, 4'), la face active (10, 10') de ces composants étant dans un même plan qu'une face (8), dite face avant, de la plaquette d'accueil,
- un matériau (6) d'enrobage latéral des composants dans les cavités,
- une couche d'adhésif (22) thermosensible biface et un substrat support (21), cette couche d'adhésif ayant deux faces dont chacune est adhésive et thermosensible, la face avant (8) de la plaquette d'accueil (2) étant fixée sur une des ces 2 faces, l'autre face reposant sur le substrat support, le matériau (6) d'enrobage ayant une température de durcissement inférieure à la température de décollement, qui fait perdre ses propriétés adhésives à la couche (22) d'adhésif,
- les faces actives (10, 10') des composants étant fixées sur la face de la couche d'adhésif (22) thermosensible biface sur laquelle la face avant (8) de la plaquette d'accueil (2) est fixée ;
- la face de la couche d'adhésif thermosensible biface (22) sur laquelle sont fixées la face avant (8) de la plaquette d'accueil (2) et les faces actives (10, 10') des composants ayant une température de retrait supérieure à la température de décollement du fait de la présence de points d'accroche résiduelle aux interfaces du matériau d'enrobage et de la couche d'adhésif.

11. Procédé selon l'une des revendications 1 à 9, ou dispositif électronique selon la revendication 10, la couche (22) d'adhésif thermosensible biface étant du type comportant une couche (220) de PET recouverte de chaque côté d'un film de matériau thermoexpansible (221, 222) qui perd ses propriétés adhésives lorsqu'il est chauffé.

## Patentansprüche

1. Verfahren zur Integration von diskreten Komponenten (4, 4') in einer Platte (2), genannt Empfangsplatte, zum Bilden einer integrierten elektronischen Vorrichtung von diskreten Komponenten,
wobei diese Platte Hohlräume (5) aufweist, die dazu ausgelegt sind, die Komponenten zu empfangen, bei welchem Verfahren:
a) man einen Stapel realisiert, umfassend einen Träger (21), eine Schicht (22) aus wärmeempfindlichem Haftmittel mit zwei Flächen, wobei diese Haftmittelschicht zwei Flächen hat, von denen jede haftend und wärmeempfindlich ist, wobei die Platte (2) und die Komponenten (4, 4'), die in den Hohlräumen (5) angeordnet sind, derart sind, dass ihre aktive Fläche (10) in ein und derselben Ebene ist wie eine Fläche (8), genannt Vorderfläche, der Empfangsplatte, wobei diese Vorderfläche mit der Schicht (22) aus wärmeempfindlichen Haftmittel mit zwei Flächen zusammengefügt ist,
b) man ein Material (6) zur lateralen Verkleidung der Komponenten in die Hohlräume injiziert, wobei die Aushärtetemperatur dieses Materials (6) kleiner ist als die Ablösetemperatur, die bewirkt, dass die Schicht (22) aus wärmeempfindlichem Haftmittel mit zwei Flächen ihre Hafteigenschaften verliert,
c) man eine Aushärtung durch Erhitzen des Verkleidungsmaterials (6) auf eine Temperatur realisiert, die die Hafteigenschaften der Schicht (22) aus wärmeempfindlichem Haftmittel mit zwei Flächen nicht unterdrückt,
d) man dann den Träger (21) und die Schicht aus wärmeempfindlichem Haftmittel mit zwei Flächen (22) entfernt, zuerst durch einen ersten Temperaturanstieg, um die Ablösetemperatur der Schicht aus wärmeempfindlichem Haftmittel mit zwei Flächen (22) zu überschreiten und den Träger (21) abzulösen, dann durch einen zweiten Temperaturanstieg, um Restbefestigungspunkte an den Grenzflächen des Verkleidungsmaterials und der Haftschicht zu beseitigen, um die Haftmittelschicht (22) von der Platte zu separieren.

2. Verfahren nach Anspruch 1, umfassend einen vorhergehenden Schritt der Bildung einer elektrisch isolierenden Schicht (20) auf wenigstens einem Teil der Oberflächen der Platte nach der Bildung der Hohlräume (5).

3. Verfahren nach einem der Ansprüche 1 oder 2, bei dem der Schritt a) umfasst:
a1) eine vorhergehende Zusammenfügung der Haftmittelschicht (22) mit der Platte (2), dann eine Zusammenfügung des Trägers (21) mit der Haftmittelschicht, wobei die Komponenten auf dieser Haftmittelschicht vor oder nach der Zusammenfügung der Platte mit der Haftmittelschicht angeordnet werden;
a'1) oder eine vorhergehende Zusammenfügung der Haftmittelschicht (22) mit dem Träger (21), dann eine Zusammenfügung der Platte (2) mit der Haftmittelschicht (22), wobei die Komponenten auf dem Haftmittel vor oder nach der Zusammenfügung der Platte mit der Haftmittelschicht angeordnet werden.

4. Verfahren nach einem der Ansprüche 1 bis 3, ferner umfassend einen Schritt des Abdünnens der Rückfläche der Empfangsplatte (2) nach dem Schritt c).

5. Verfahren nach einem der Ansprüche 1 bis 4, ferner umfassend nach dem Schritt c) und vor oder nach dem Schritt d), einen Schritt des Zusammenfügens der Platte mit einem Verstärkungssubstrat (30).

6. Verfahren nach einem der Ansprüche 1 bis 5, wobei wenigstens ein Teil der Hohlräume (5) derart realisiert wird, dass sie die Empfangsplatte über ihre gesamte Dicke durchsetzen und auf jede ihrer Flächen (8, 8') münden.

7. Verfahren nach einem der Ansprüche 1 bis 6, wobei die Empfangsplatte ferner eine oder mehrere Komponenten und/oder ein oder mehrere Visiere (25, 27, 29) umfasst.

8. Verfahren nach einem der Ansprüche 1 bis 7, wobei das Material der Platte (2) einen thermischen Ausdehnungskoeffizienten hat, der zwischen 2 ppm/°C und 7 ppm/°C enthalten ist, und/oder das Material zur lateralen Verkleidung (6) ein Endvolumen hat, das kleiner als 30% des Volumens der Gesamtheit der Platte ist.

9. Verfahren nach einem der Ansprüche 1 bis 8, wobei der Träger (21) abgelöst wird, während das Verkleidungsmaterial noch nicht vollständig ausgehärtet ist.

10. Integrierte elektronische Vorrichtung von diskreten Komponenten, umfassend:
- eine Platte (2), genannt Empfangsplatte, die Hohlräume (5) aufweist, die die Komponenten (4, 4') enthalten, wobei die aktive Fläche (10, 10') dieser Komponenten in ein und derselben Ebene ist wie eine Fläche (8), genannt Vorderfläche, der Empfangsplatte,
- ein Material (6) zur lateralen Verkleidung der Komponenten in den Hohlräumen,
- eine Schicht (22) aus wärmeempfindlichem Haftmittel mit zwei Flächen und ein Trägersubstrat (21), wobei diese Haftmittelschicht zwei Flächen hat, von denen jede haftend und wärmeempfindlich ist, wobei die Vorderfläche (8) der Empfangsplatte (2) an einer dieser zwei Flächen befestigt ist, wobei die andere Fläche auf dem Trägersubstrat ruht, wobei das Verkleidungsmaterial (6) eine Aushärtungstemperatur hat, die kleiner ist als die Ablösetemperatur, die bewirkt, dass die Haftmittelschicht (22) ihre Hafteigenschaften verliert,
- wobei die aktiven Flächen (10, 10') der Komponenten an der Fläche der wärmeempfindlichen Haftmittelschicht (22) mit zwei Flächen befestigt sind, an der die Vorderfläche (8) der Empfangsplatte (2) befestigt ist;
- wobei die Fläche der wärmeempfindlichen Haftmittelschicht mit zwei Flächen (22), an der die Vorderfläche (8) der Empfangsplatte (2) und die aktiven Flächen (10, 10') der Komponenten befestigt sind, eine Entfernungstemperatur hat, die größer ist als die Ablösetemperatur, aufgrund des Vorhandenseins von Restbefestigungspunkten an den Grenzflächen des Verkleidungsmaterials und der Haftmittelschicht.

11. Verfahren nach einem der Ansprüche 1 bis 9 oder elektronische Vorrichtung nach Anspruch 10, wobei die Schicht (22) aus wärmeempfindlichem Haftmittel mit zwei Flächen von dem Typ ist umfassend eine Schicht (220) aus PET, die auf jeder Seite mit einem Film aus wärmeexpandierbarem Material (221, 222) bedeckt ist, der seine Hafteigenschaften verliert, wenn er erhitzt wird.

## Claims

1. A method for integrating discrete components (4, 4') in a wafer (2), said receiving wafer, to form an integrated electronic device with discrete components, this wafer having cavities (5) capable of receiving said components, a method wherein:
a) a stack is made including a support (21), a double face thermosensitive adhesive layer(22), this adhesive layer having two faces, each of which is adhesive and thermosensitive, the wafer (2) and the components (4, 4') positioned in said cavities (5) so that their active face (10) is in a same plane as a face (8), a so-called front face, of the receiving wafer, this front face being assembled with the layer (22) of double face thermosensitive adhesive,
b) a material (6) for laterally coating the components is injected into the cavities, the hardening temperature of this material (6) being less than the detachment temperature, above which said double face thermosensitive adhesive layer (22) loses its adhesive properties,
c) said material (6) for laterally coating the components is hardened by heating to a temperature which does not suppress the adherence properties of said double face thermosensitive adhesive layer (22);
d) then the support (21) and the double face thermosensitive adhesive layer (22) are removed, first by a 1^{st} rise in temperature, in order to exceed the temperature for detaching the double face thermosensitive adhesive layer (22) and detach the support (21), then by a 2^{nd} rise in temperature, in order to eliminate points of residual attachment at the interfaces of the coating material and of the adhesive layer in order to separate the adhesive layer (22) from the wafer.

2. The method according to claim 1, including a preliminary step for forming an electrically insulating layer (20) on at least one portion of the surfaces of the wafer, after forming the cavities (5).

3. The method according to one of claims 1 or 2, wherein step a) includes:
a1) a preliminary assembly of the adhesive layer (22) with the wafer (2), and then an assembly of the support (21) with the adhesive layer, the components being positioned on this adhesive layer before or after assembling the wafer with the adhesive layer;
a'1) or a preliminary assembly of the adhesive layer (22) with the support (21), and then an assembly of the wafer (2) with the adhesive layer (22), the components being positioned on the adhesive before or after assembling the wafer with the adhesive layer.

4. The method according to any of claims 1 to 3, further including a step for thinning the rear face of the receiving wafer (2), after step c).

5. The method according to any of claims 1 to 4, further including, after step c) and before or after step d), a step for assembling the wafer with a stiffening substrate (30).

6. The method according to any of claims 1 to 5, at least one portion of the cavities (5) passing through the receiving wafer over the whole of its thickness and opening out on each of its faces (8, 8').

7. The method according to any of claims 1 to 6, the receiving wafer further including at least one component and/or one or more patterns (25, 26).

8. The method according to any of claims 1 to 7, the material of the wafer (2) having a heat expansion coefficient comprised between 2 ppm/°C and 7 ppm/°C and/or the lateral coating material (6) having a final volume of less than 30% of the volume of the whole of the wafer.

9. The method according to any of claims 1 to 8, the support (21) being detached while the coating material is not yet completely hardened.

10. An electronic device integrated with discrete components, comprising:
- a wafer (2), so-called receiving wafer, having cavities (5) containing said components (4, 4'), the active face (10, 10') of these components being in a same plane as a face (8), a so-called front face, of the receiving wafer,
- a material (6) laterally coating the components in the cavities,
- an adhesive layer (22) in a double face thermosensitive material and a support substrate (21), this adhesive layer having two faces, each of which is adhesive and thermosensitive, the front face (8) of the receiving wafer (2) being fixed to one of these 2 faces, the other face resting on the support substrate, the hardening temperature of said material (6) laterally coating the components in the cavities being less than the detachment temperature, above which said double face thermosensitive adhesive layer (22) loses its adhesive properties,
- the active faces (10, 10') of the components being fixed on the face of the double face thermosensitive adhesive layer (22) on which the front face (8) of the receiving wafer (2) is fixed;
- the face of the double face thermosensitive adhesive layer (22) on which the front face (8) of the receiving wafer (2) and the active faces (10, 10') of the components are fixed having a removal temperature higher than the detachment temperature due to the presence of points of residual attachment at the interfaces of the coating material and of the adhesive layer.

11. Method according to one of claims 1 to 9 or electronic device according to claim 10, the thermosensitive adhesive layer (22) being of the type including a PET layer (220) covered on each side with a film of thermo-expansible material (221, 222) which loses its adhesive properties when it is heated.
